# EUROPEAN PATENT APPLICATION

(11) **EP 4 718 157 A1**
(43) Date of publication of application: **01.04.2026**
(21) Application number: 24203631.7
(22) Date of filing: 30.09.2024
(51) Int. Cl.: G03F 7/00, G01R 29/24, G01R 15/24

(54) **DIAGNOSTIC SUBSTRATE, POCKELS SENSOR, AND METHOD FOR CHARGE DETERMINATION**

(71) Applicant: ASML Netherlands B.V., 5500 AH Veldhoven (NL)
(72) Inventor: VAN EDEN, Gustaaf, Galein, 5500 AH Veldhoven (NL); LIMBURG, Anne, Aafke, Aïda, 5500 AH Veldhoven (NL); RAAYMAKERS, Jeroen, Arnoldus, Leonardus, Johannes, 5500 AH Veldhoven (NL)
(74) Representative: ASML Netherlands B.V.

(57) **Abstract**

A diagnostic substrate, such as a wafer or reticle, is disclosed for use in determination of a charge on a surface of an electrostatic clamp configured to support the diagnostic substrate,
the substrate comprising a stack of: a dielectric light reflector layer, an electro-optic crystal layer, and a transparent electrode layer. The electro-optic crystal layer is between the dielectric light reflector layer and the transparent electrode layer. A Pockels sensor may comprise the diagnostic substrate.

## Description

### FIELD

The present invention relates to a diagnostic substrate, such as a wafer or reticle, for use in determination of a charge on a surface of an electrostatic clamp, a Pockels sensor comprising said diagnostic substrate, a substrate stage comprising said Pockels sensor, an exposure apparatus comprising said substrate stage, and a method for determination of charges on a surface of an electrostatic clamp, using said diagnostic substrate.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern at a patterning device (e.g., a mask) onto a layer of radiation-sensitive material (resist) provided on a substrate.

To project a pattern on a substrate a lithographic apparatus may use electromagnetic radiation. The wavelength of this radiation determines the minimum size of features which can be formed on the substrate. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

The substrate may be supported by a substrate table, and may be held by a clamp, such as an electrostatic clamp. The electrostatic clamp may exert a clamping force on the substrate by application of an electrostatic charge.

Surface charging of the clamp may be a source of various issues. For example, charging may impact a performance of the lithographic apparatus and may be a source of defectivity, as a result of particle creation by discharges, etc.. For this reason, surface potential scans may be applied to detect the surface charges, such as using Electrostatic Volt Meters (ESVM).

The disadvantage of using the ESVM may be that it is relatively slow, providing a point by point measurement, that it has a limited spatial resolution and that measurements cannot be performed during clamping.

### SUMMARY

The invention aims to enhance a measurement of electrostatic charge at an electrostatic clamp.

According to an aspect, there is provided a diagnostic substrate, such as a wafer or reticle, for use in determination of a charge on a surface of an electrostatic clamp configured to support the diagnostic substrate, the substrate comprising a stack of:
- a dielectric light reflector layer,
- an electro-optic crystal layer, and
- a transparent electrode layer,
wherein the electro-optic crystal layer is between the dielectric light reflector layer and the transparent electrode layer.

According to another aspect, there is provided a Pockels sensor for determination of said surface charges, comprising said diagnostic substrate,
wherein the Pockels sensor further comprises:
- a light source,
- a polarizing beam splitter, and
- an optical sensor, configured and arranged so that in use light is generated by the light source, the light passing through the polarizing beam splitter and onto the diagnostic substrate, where it passes through the electro-optic crystal layer and is reflected back by the dielectric light reflector layer, through the polarizing beam splitter and wherein a polarization state dependent part of the light is incident onto the optical sensor.

According to yet another aspect, there is provided a substrate stage comprising said Pockels sensor.

According to a further aspect, there is provided an exposure apparatus comprising said substrate stage.

According to a yet further aspect, there is provided a method for determination of charges on a surface of an electrostatic clamp, using said diagnostic substrate, the method comprising:
- placing the diagnostic substrate on the electrostatic clamp;
- generating collimated light by a light source,
- passing the light through a polarizing beam splitter and onto the diagnostic substrate,
- reflecting by the dielectric light reflector layer of the diagnostic substrate the light back through the polarizing beam splitter and wherein a polarization state dependent part of the light is incident onto the optical sensor, and
- determining the charge on the surface of the electrostatic clamp from an output signal of the optical sensor.

### BRIEF DESCRIPTION OF THE DRAWINGS

Embodiments of the invention will now be described, by way of example only, with reference to the accompanying schematic drawings, in which:
- Figure 1 depicts a lithographic system comprising a lithographic apparatus and a radiation source;
- Figure 2 depicts a highly schematic view of a part of a diagnostic substrate according to an aspect;
- Figure 3 depicts a highly schematic view of a Pockels sensor according to an aspect; and
- Figure 4 depicts a curve of sensor output versus charge of the Pockels sensor......

### DETAILED DESCRIPTION

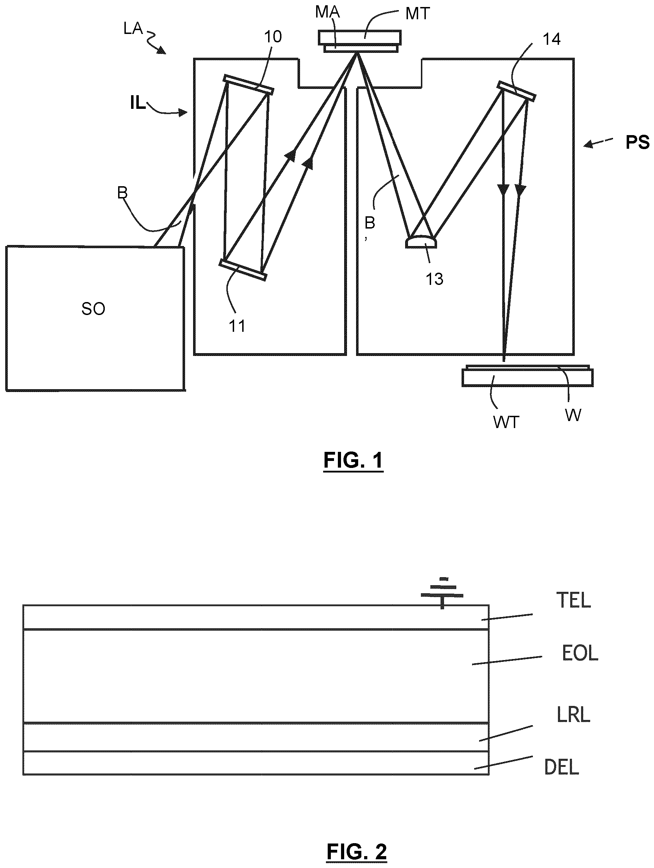

Figure 1 shows a lithographic system comprising a radiation source SO and a lithographic apparatus LA. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask), a projection system PS and a substrate table WT configured to support a substrate W.

The illumination system IL is configured to condition the EUV radiation beam B before the EUV radiation beam B is incident upon the patterning device MA. Thereto, the illumination system IL may include a facetted field mirror device 10 and a facetted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 13,14 which are configured to project the patterned EUV radiation beam B' onto the substrate W held by the substrate table WT. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 13,14 in Figure 1, the projection system PS may include a different number of mirrors (e.g. six or eight mirrors).

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the projection system PS.

The radiation source SO may be a laser produced plasma (LPP) source, a discharge produced plasma (DPP) source, a free electron laser (FEL) or any other radiation source that is capable of generating EUV radiation.

Figure 2 depicts a highly schematic view of a diagnostic substrate DS, or at least a central part thereof, according to an aspect. The diagnostic substrate comprises a stack of a dielectric light reflector layer LRL, an electro-optic crystal layer EOL, and a transparent electrode layer TEL. Optionally, a dielectric layer DEL may be arranged at a bottom of the stack. The diagnostic substrate may further comprise a body part B surrounding said stack. The dielectric light reflector layer is configured to reflect a light beam, as will be explained further below. The electro-optic crystal layer is configured to adapt a polarization state of light passing through the layer, in dependency of an magnitude of an electric field to which the electro-optic crystal layer is subject. The transparent electrode is configured to be grounded in use, hence providing a defined ground potential at one side of the electro-optic crystal, while at the same time being substantially transparent, so as to enable the light to pass the transparent electrode. The diagnostic substrate is configured to enable light having a polarization state to enter through the transparent electrode, pass through the electro-optic crystal layer where the polarization state may be altered, depending on a magnitude of the electric field, the light being reflected by the dielectric reflector layer after which the light propagates back through the electro-optic crystal layer, where the propagation state is altered again, and the transparent electrode layer. As the electro-optic crystal layer is between the dielectric light reflector layer and the transparent electrode layer, the incident light may pass through the electro-optic crystal layer twice and be reflected back by the dielectric light reflector layer, while providing a ground potential by grounding the transparent electrode layer at the side of the electro-optic crystal layer facing away, in use, from the electrostatic clamp. The stack of the layers may be comprised in a diagnostic substrate, such as a wafer or a patterning device (i.e. a reticle). As will be explained in more detail below, when clamping the diagnostic substrate, e.g. by an electrostatic clamp, an electric charge may be detected in that the electric field resulting from the electric charge may provide for a polarization change of the light passing through the electro-optic crystal layer. A two dimensional image of the light passing through the electro optic crystal layer may be detected, from which information regarding a two dimensional distribution of electrical charge may be derived, on the basis of the electrical field dependent polarization change of the electro-optic crystal layer, as explained in more detail below.

As mentioned, optionally, a dielectric layer DEL may be arranged at a bottom of the stack. The dielectric reflector may already be an insulator so without the dielectric layer the measurements may also work. The (additional) dielectric layer, which faces the electrostatic clamp during use and which is thus in contact with the clamp, may enable to more freely choose the material for the dielectric layer such as to be the same or similar as a backside layer of a wafer used during exposure, while also being able to optimize the dielectric reflector, such as the thickness and material type, according to the functioning of the reflector.

The stack as depicted in and described with reference to Figure 2 may be arranged in a substrate, such as a wafer or a patterning device. For example, the stack may be arranged in a window of the substrate.

During use, i.e. during a charge determination using the diagnostic wafer, the dielectric light reflector layer is configured to be arranged, in use, between the electro-optic crystal layer and the surface of the electrostatic clamp. Thus, light incident from a light source, may propagate through the electro optic crystal layer, and be reflected by the dielectric light reflector, to propagate back through the electro optic crystal layer. Hence, on the one hand, the electro optic crystal layer may affect a polarization of the light twice, enhancing a sensitivity to an electric field by a factor 2, thus enhancing a sensitivity to an electrostatic charge. Moreover, the dielectric light reflector layer may reflect the light back towards a side where the light entered the stack, hence enabling to position the sensor on a non-optically transparent electrostatic clamp, as, in use, the light may enter and exit the stack from the same side, i.e. the side facing away from the electrostatic clamp.

In an embodiment, the dielectric light reflector layer comprises a Bragg mirror. The Bragg mirror may comprise plural dielectric layers. For example, the dielectric light reflector layer comprises plural dielectric layers alternatingly having a higher refractive index and a lower refractive index, hence providing a high reflectivity to the incident light. These layers preferably have a high contrast in refractive indexes to provide a high reflectivity.

As mentioned above, the electro-optic crystal layer may be configured to change an optical polarization of incident light in dependency on an electric field to which the electro-optic crystal layer is subject.

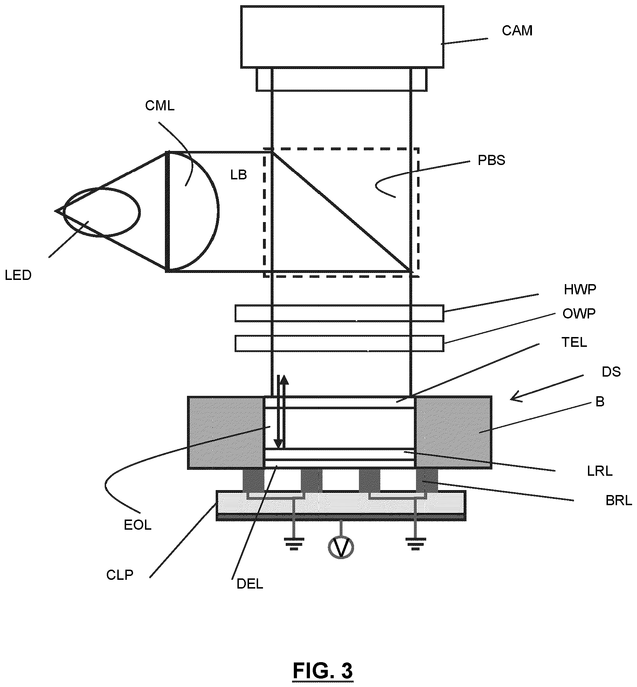

Figure 3 depicts a Pockels sensor according to an aspect. The Pockels sensor comprises the diagnostic substrate as described above with reference to Figure 2. An LED is configured to emit light, such a visible or near infrared light. The light may be in the visible wavelength range as detectors are more sensitive and alignment is easier, preferably with a bandwidth of about 10 nm or less. The signal strength (intensity difference) may be directly dependent on the wavelength and might thus be accurately defined with a defined wavelength. Furthermore, the polarization state may be more accurately defined when a specific wavelength is used.

A collimator lens CML transfers the light into a collimated light beam LB which is incident on polarizing beam splitter PBS, where the light beam is (at least partly) reflected to Half wave plate HWP, enabling to enhance a sensitivity, and Octadic wave plate OWP, enabling to distinguish between negative and positive charges. Having propagated through the Half wave plate and Octadic wave plate, the light propagates into the stack of the diagnostic substrate DS, namely the transparent electrode layer TEL, the electro-optic crystal layer EOL, and the dielectric light reflector layer LRL, where the light is reflected back, via the electro-optic crystal layer and the transparent electrode layer to the octadic wave plate and half wave plate, and via the polarizing beam splitter to a camera CAM. Thus, light with a different polarization state than the light that propagates from the polarizing beam splitter to the diagnostic substrate may reach the optical sensor. Correspondingly, when an electric field is present over the electro-optic crystal, thus altering a polarization state of the incident light, light incident on the sensor will change.

As depicted in Figure 3, the stack of the diagnostic substrate is arranged on an electrostatic clamp, such as an electrostatic clamp CLP of a substrate table. The substrate table comprises a plurality of burls BRL, i.e. protrusions, on which the diagnostic substrate is carried. The electrostatic clamp is configured to electrostatically clamp the substrate (such as in the present example the diagnostic substrate) by the application of an electrostatic field. For this purpose, the transparent electrode layer may be provided in the substrate, and may for example be connected to electrical ground.

A measurement of a build up of charge may be performed in that (global or local) changes in the electric field at the electro-optic crystal layer of the stack result in global or local changes in the polarization of the light transmitted back from the stack to the polarizing beam splitter, resulting in a (global or local) intensity change at the camera. Hence, a build up of charge may be measured in use, i.e. as the electrostatic clamp is operational, and may be measured simultaneously over the surface of the electrostatic clamp as covered by the stack of the diagnostic substrate, i.e. simultaneously over a two dimensional surface of the electrostatic clamp.

The Pockels sensor may further comprise a data processing device configured to determine the charge on the surface of the electrostatic clamp from an output signal of the optical sensor, i.e. in the present example from the output signal of the camera.

In an embodiment, the optical sensor comprises a camera configured to provide a two dimensional output signal, e.g. representing an intensity of the light at the detector, and wherein the data processing device is configured to determine a two dimensional image of a distribution of the charge on the surface of the electrostatic clamp from the two dimensional output signal provided by the camera. Alternatively, the optical sensor may comprise a photodetector, such as a photodiode or other light sensor and a scanner to scan the photodetector along an image plane of the optical sensor so as to generate a two dimensional image.

In an embodiment, the data processing device further comprises a geometric point spread function, and wherein the data processing device is configured to determine the two dimensional image of the distribution of the charge on the surface of the electrostatic clamp using the geometric point spread function. For example, a deconvolution may be used. The geometric point spread function may represent an expected geometric distribution of the electrostatic field as a result of a (local) buildup of charge. Thereby, a geometric spreading effect of a local electrostatic charge may be taken into account to more specifically localize a buildup of electrostatic charge. The electric field induced in the electro-optic crystal by the surface charge may be wider than a spot of the surface charge. The electro-optic crystal may be at some (small) distance away from the charge and thus the field there may even be wider. Such geometric spreading effect may be taken into account by the geometric spread function.

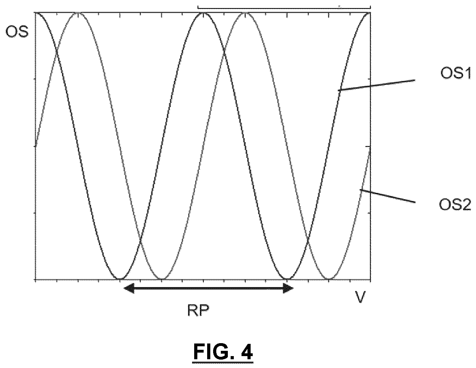

Figure 4 depicts a graphical view of optical sensor output signal OS (such as in the present example camera output signal) along the vertical axis as a function of an electrical voltage V over the electro optic crystal layer along the horizontal axis. As the electrical voltage over the electro optic crystal layer increases, the electrical field over the electro optic crystal layer increases, resulting in an effect of the electro optic crystal layer on the polarization of the light to increase. As the polarization rotates, the intensity of the light incident on the optical sensor (i.e. in the present example, the camera) periodically increases and decreases according to a sine function at a polarization repetition period RP. OS1 and OS2 show a signal dependency on the voltage V for two different input wavelengths of the light source. Different wavelengths may result in different efficiencies/sensitivities, hence in a different range.

In an embodiment, the electro-optic crystal layer is configured to periodically change, according to a polarization repetition period, the polarization of the light responsive to an increase of the charge on the surface of the electrostatic clamp, and wherein the data processing device is configured to determine the charge on the surface of the electrostatic clamp using a range of a half of the polarization repetition period. Using a half of the polarization repetition period, preferably from a minimum to a maximum, a defined relation between the polarization and the electrostatic field, thus the electrostatic charge, may be provided.

As another example, in an embodiment, the electro-optic crystal layer is configured to periodically change, according to a polarization repetition period, the polarization of the light responsive to an increase of the charge on the surface of the electrostatic clamp, and wherein the data processing device is configured to determine the charge on the surface of the electrostatic clamp using a range of at least a half of one polarization repetition period. Accordingly, a larger range of magnitude of the electrostatic field may be detected, requiring to take account of a periodicity of the polarization change, hence a periodicity of the intensity of the optical signal as detected by the camera.

According to an aspect, there is provided a substrate stage comprising the Pockels sensor. The substrate stage may further comprise a base frame and a position module supported in a movable manner on the base frame, for moving the clamp during use, optionally for moving the clamp relative to the Pockels sensor during use.

According to an aspect, there is provided an exposure apparatus comprising the substrate stage. The exposure apparatus may comprise e.g. a lithographic apparatus or an inspection apparatus. The exposure apparatus, such as described with reference to Figure 1, may further comprise a source of radiation, such as DUV radiation or EUV radiation, and a projection system to project the radiation onto a substrate.

According to an aspect, there is provided a method for determination of charges on a surface of an electrostatic clamp, using said diagnostic substrate, the method comprising:
- placing the diagnostic substrate on the electrostatic clamp;
- generating collimated light by a light source,
- passing the light through a polarizing beam splitter and onto the diagnostic substrate,
- reflecting by the dielectric light reflector layer of the diagnostic substrate the light back through the polarizing beam splitter and wherein a polarization state dependent part of the light is incident onto the optical sensor, and
- determining the charge on the surface of the electrostatic clamp from an output signal of the optical sensor.

By said method, the same or similar advantages and effects may be achieved as with said diagnostic substrate and/or Pockels sensor. Also, the same or similar embodiments may be provided, achieving the same or similar effects as described with reference to the diagnostic substrate and/or Pockels sensor.

With said Pockels sensor and/or said method, the substrate may or may not be clamped by the electrostatic clamp by generating an electrostatic attraction force using electrodes of the clamp. The charging may generally take place during the clamping. For example, the substrate may be clamped by the clamp by applying a voltage on the clamp and grounding the transparent electrode layer of the substrate. The remaining charge may be measured using the Pockels sensor and/or the method. For the functioning of the diagnostic to detect a remaining charge on e.g. the support, the clamping may not be necessary. If charges are already present on the clamp surface, they can be measured by the diagnostic substrate if the substrate electrode is grounded.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

Where the context allows, embodiments of the invention may be implemented in hardware, firmware, software, or any combination thereof. Embodiments of the invention may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic storage media; optical storage media; flash memory devices; electrical, optical, acoustical or other forms of propagated signals (e.g. carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc. and in doing that may cause actuators or other devices to interact with the physical world.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

## Claims

1. A diagnostic substrate, such as a wafer or reticle, for use in determination of a charge on a surface of an electrostatic clamp configured to support the diagnostic substrate,
the substrate comprising a stack of:
- a dielectric light reflector layer,
- an electro-optic crystal layer, and
- a transparent electrode layer,
wherein the electro-optic crystal layer is between the dielectric light reflector layer and the transparent electrode layer.

2. The diagnostic substrate according to claim 1, wherein the dielectric light reflector layer is configured to be arranged, in use, between the electro-optic crystal layer and the surface of the electrostatic clamp.

3. The diagnostic substrate according to claim 1 or 2, wherein the dielectric light reflector layer comprises a Bragg mirror.

4. The diagnostic substrate according to any one of the preceding claims, wherein the dielectric light reflector layer comprises plural dielectric layers in turn having a higher refractive index and a lower refractive index.

5. The diagnostic substrate according to any one of the preceding claims, wherein the electro-optic crystal layer is configured to change an optical polarization of incident light in dependency on an electric field to which the electro-optic crystal layer is subject.

6. A Pockels sensor for determination of said surface charges, comprising the diagnostic substrate according to any one of the preceding claims,
wherein the Pockels sensor further comprises:
- a light source,
- a polarizing beam splitter, and
- an optical sensor, configured and arranged so that in use light is generated by the light source, the light passing through the polarizing beam splitter and onto the diagnostic substrate, where it passes through the electro-optic crystal layer and is reflected back by the dielectric light reflector layer, through the polarizing beam splitter and wherein a polarization state dependent part of the light is incident onto the optical sensor.

7. The Pockels sensor according to claim 6, further comprising a data processing device configured to determine the charge on the surface of the electrostatic clamp from an output signal of the optical sensor.

8. The Pockels sensor according to claim 7, wherein the optical sensor comprises a camera configured to provide a two dimensional output signal, and wherein the data processing device is configured to determine a two dimensional image of a distribution of the charge on the surface of the electrostatic clamp from the two dimensional output signal provided by the camera.

9. The Pockels sensor according to claim 8, wherein the data processing device further comprises a geometric point spread function, and wherein the data processing device is configured to determine the two dimensional image of the distribution of the charge on the surface of the electrostatic clamp using the geometric point spread function.

10. The Pockels sensor according to any one of claims 7-9, wherein the electro-optic crystal layer is configured to periodically change, according to a polarization repetition period, the polarization of the light responsive to an increase of the charge on the surface of the electrostatic clamp, and wherein the data processing device is configured to determine the charge on the surface of the electrostatic clamp using a range of a half of the polarization repetition period.

11. The Pockels sensor according to any one of claims 7-9, wherein the electro-optic crystal layer is configured to periodically change, according to a polarization repetition period, the polarization of the light responsive to an increase of the charge on the surface of the electrostatic clamp, and wherein the data processing device is configured to determine the charge on the surface of the electrostatic clamp using a range of at least a half of the polarization repetition period.

12. A substrate stage comprising the Pockels sensor according to any one of claims 6 - 11.

13. An exposure apparatus comprising the substrate stage according to claim 12.

14. A method for determination of charges on a surface of an electrostatic clamp, using said diagnostic substrate according to any one of claims 1 - 5, the method comprising:
- placing the diagnostic substrate on the electrostatic clamp;
- generating collimated light by a light source,
- passing the light through a polarizing beam splitter and onto the diagnostic substrate,
- reflecting by the dielectric light reflector layer of the diagnostic substrate the light back through the polarizing beam splitter and wherein a polarization state dependent part of the light is incident onto the optical sensor, and
- determining the charge on the surface of the electrostatic clamp from an output signal of the optical sensor.
